# EUROPÄISCHE PATENTSCHRIFT

(11) **EP 1 116 421 B1**
(45) Veröffentlichungstag und Bekanntmachung des Hinweises auf die Patenterteilung: **04.06.2003**
(21) Anmeldenummer: 99946145.2
(22) Anmeldetag: 09.09.1999
(51) Int. Cl.: H05K 3/06, H05K 3/42

(54) **VERFAHREN ZUR HERSTELLUNG VON GEÄTZTEN SCHALTUNGEN**
METHOD FOR PRODUCING ETCHED CIRCUITS
PROCEDE DE REALISATION DE CIRCUITS FORMES PAR ATTAQUE

(30) Priorität: 18.09.1998 CH 191298
(43) Veröffentlichungstag der Anmeldung: 18.07.2001
(73) Patentinhaber: Vantico AG, 4057 Basel (CH)
(72) Erfinder: MEIER, Kurt, CH-4106 Therwil (CH); LACHER, Ulrich, D-79594 Inzlingen (DE)
(74) Vertreter: Dannappel, Hans-Jochen, Dr.
(86) Internationale Anmeldenummer: EP9906618
(87) Internationale Veröffentlichungsnummer: WO00018199

(56) Entgegenhaltungen:
- EP-A- 0 204 415
- WO-A-87/07980
- DE-A- 3 732 249
- FR-A- 1 445 569
- GB-A- 830 187

## Beschreibung

Die vorliegende Erfindung betrifft ein Verfahren zur Herstellung von Leiterplatten mit Durchkontaktierungen.

Ein Problem bei der Strukturierung von durchkontaktierten Kupferlaminaten ist der Schutz der Bohrungen gegen das Ätzmedium.

In *M. Hummel:* "Einführung in die Leiterplattentechnologie", Seiten 98-100, Eugen G. Lenze Verlag AG (1991), wird zur Lösung dieses Problems die "Tenting-Technik" vorgeschlagen. Als Ätzresist dient dabei ein Feststoffilm (Trockenfitmresist), der sich wie ein Zelt über die Bohrungen legt Ein Nachteil dieser Methode ist jedoch das Auftreten von annularen Ringen aus Kupfer um die Durchkontaktierungen herum, wodurch die Verdrahtungsdichte der Leiterplatte eingeschränkt wird.

Neben der 'Tenting' -Technik ist der gegenwärtige Stand der Strukturierung von Leiterplatten das Metallresistverfahren wie z. B. in der W087/07980 beschrieben, insbesondere für die Strukturierung von Feinstleitem bis 100 µm Leiterbreite,. Diese Technik beinhaltet das Laminieren eines negativ arbeitenden, trockenen Fotofilms nach dem Heisswalzenlaminierverfahren, Belichten der Struktur, Entwickeln, Galvanisieren des Leiterbildkupfers, anschliessendem Aufbringen eines Metallresistes (Zinn), Entschichten des Fotofilms, ammoniakalischem Ätzen des Leiterbildes und anschliessendem Strippen des Resistes.

Gemäß *H*. *Schwab:* "Electrodeposition of Photoresists for Printed Wiring Board Application", EIPC Winter Conference 1992, können solche annularen Ringe reduziert oder sogar völlig eliminiert werden, wenn als Ätzresist ein mittels Elektrotauchlackierung (electrodeposition) aufgebrachter Positiv-Photoresist verwendet wird. Die üblicherweise in der Technik eingesetzten Positiv-Photoresists benötigen jedoch relativ lange Belichtungszeiten. Außerdem ist die Elektrotauchlackierung mit erheblichem technischem Aufwand verbunden.

Aufgabe der vorliegenden Erfindung war es, ein weniger aufwendiges Verfahren zur Strukturierung von durchkontaktierten Innen- und Außenlagen zu entwickeln.

Es wurde nun gefunden, daß bei der Verwendung eines flüssigen, negativ arbeitenden Galvanoresists die BPidung von annularen Ringen wesentlich reduzlert oder völlig vermieden werden kann.

Gegenstand der vorliegenden Erfindung ist ein Verfahren zur Herstellung von Leiterplatten mit Durchkontaktierungen, gekennzeichnet durch die folgenden Verfahrensschritte:
(A) beidseitiges Beschichten eines durchkontaktierten Kupferlaminats mit einem flüssigen Negativ-Galvanoresist;
(B) Strukturierung der Resistbeschichtung durch bildmäßiges Belichten, wobei die Durchkontaktierungen durch eine Maske abgedeckt werden, und anschließendes Entwickeln;
(C) Galvanisches Aufbringen eines Metallresists;
(D) Entfernung des auf dem Laminat verbliebenen, vernetzten Negativ Galvanoresists;
(E) Entfernung des freiliegenden Kupfers mittels einer Ätzlösung; und
(F) Entfernung des Metallresists mittels einer Stripperlösung.

Die Erfindung wird durch die zugehörigen Zeichnungen veranschaulicht.

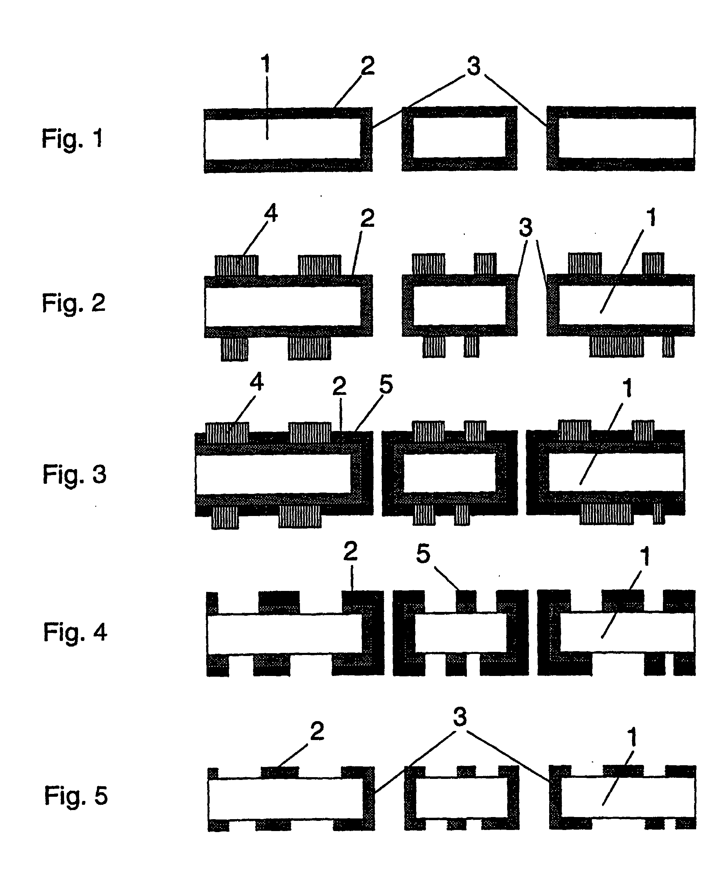

Figur 1 zeigt ein Kupferlaminat (Innen- oder Außenlage mit Durchkontaktierungen 3), das im Verfahrensschritt (A) mit Gblichen Methoden, z.B. durch Schleudern, Tauchen, Rakelbeschichtung, Vorhangguß, Siebdruck, Aufpinseln, Sprühen, Elektrostatisches Sprühen oder Rollenbeschichtung, mit einem flüssigen Negativ-Photoresist beschichtet wird.

Kupfertaminate bestehen im allgemeinen aus einem isolierenden Substrat (1, Fig. 1), welches auf beiden Seiten mit einer dünnen Kupferfolie (2, Fig. 1, Schichtdicke ca. 10-50 µm) beschichtet ist.
Glasfaserverstärkte Epoxidharze, insbesondere mit geeigneten Flammschutzmitteln versehene Epoxidharze, werden bevorzugt als isolierendes Substrat für Kupferlaminate eingesetzt (FR-4-Laminate).

Vorzugsweise wird das Laminat mittels Rollenbeschichtung oder Siebdruck beschichtet.

Gegebenenfalls wird das Lösungsmittel anschließend durch Trocknen im Umluft- oder Infrarotofen entfernt.

Die Dicke der so aufgebrachten getrockneten photoempfindlichen Schicht (4, Fig. 2) beträgt zweckmäßig 3-30 µm, bevorzugt 5-15 µm.

Im Verfahrensschritt (B) wird das beschichtete Laminat durch eine der aufzubringenden Struktur entsprechende Maske nach bekannten Verfahren belichtet, wobei die Resistzusammensetzung auf den später zu entfernenden Flächen ausgehärtet wird.

Gegebenenfalls wird im Anschluß an den Verfahrensschritt (B) eine thermische Nachhärtung zur vollständigen Vernetzung der Polymeren in der Resistzusammensetzung vorgenommen.

Das nicht vernetzte Polymer wird durch Behandlung mit einem Lösungsmittel, bevorzugt Wasser oder wäßrige Alkalilösung, nach bekannten Verfahren entfernt (Fig. 2).

Auf diejenigen Flächen, von denen das Photopolymer durch Entwickeln entfernt wurde, wird nun im Verfahrensschritt C mittels bekannter Methoden ein Metallresist (5, Fig. 3) galvanisch abgeschieden.

Bevorzugte Metallresists sind Zinn, Nickel, Blei, Silber, Gold oder eine Legierung enthaltend eines dieser Metalle. Besonders bevorzugt ist Zinn.

Das noch auf der Platte verbliebene vernetzte Photoresistmaterial wird im Verfahrensschritt D durch Behandlung mit einem geeigneten Lösungsmittel (Strippen), vorzugsweise wäßrige Natronlauge oder Kalilauge, entfernt, gegebenenfalls bei erhöhter Temperatur.

Anschließend wird das Laminat mit einer Kupferätzlösung, zum Beispiel einer Lösung von Cu(NH₃)₄Cl₂, KMnO₄ oder (NH₄)₂S₂O₈, behandelt, wobei die freigelegten Kupferoberflächen vollständig entfernt werden (FIG. 4).

Im letzten Prozeßschritt werden dann die geschützten Kupferleiterbahnen und Durchkontaktierungen vom Metallresist befreit. Dies geschieht nach bekannten Verfahren durch Behandlung mit einer geeigneten Stripperlösung, die zwar das Metall des Resists, nicht jedoch das Kupfer angreift und auflöst (Fig. 5). Geeignete Stripperlösungen enthalten in der Regel verdünnte Säuren, wie beispielsweise Salzsäure oder Tetrafluorborsäure.

Falls zweckmäßig, kann der Metallresist auch auf dem Kupfer belassen werden. Bei der Verwendung von Zinn als Metallresist wird vorzugsweise ein Wärmeschritt nachgeschaltet, der zu einem Umschmelzen und damit zu einer Umhüllung der Kupferflächen führt.

Auf diese Weise wird eine doppelseitige Leiterplatte mit Durchkontaktierungen erhalten, die keine oder nur sehr kleine annulare Ringe aufweisen können.

### Beispiel 1:

Eine 0,3 mm dicke, nicht-strukturierte Innenlage mit Durchkontaktierungen von 0,25 mm wird mittels eines Rollenbeschichters mit Probimage® 1020 (Negativ-Resist, Ciba Specialty Chemicals) beschichtet. Die Beschichtung wird anschliessend 5 Minuten bei 80 °C im Umluftofen getrocknet. Damit wird eine Schichtdicke des Resists von 11 µm erreicht. Anschliessend wird beidseitig durch eine Photomaske, die das zu erzeugende Leiterbild als Positivbild enthält, belichtet. Die Photomaske deckt dabei die Durchkontaktierungen mit Durchmesser 0,25 mm mit einem Punkt von 0,3 mm Durchmesser ab. Die Belichtungsenergie beträgt 150 mJ/cm². Nach dem Herauslösen (Entwickeln) der nichtvernetzten Beschichtung mit 1%-iger Natriumcarbonatlösung im Sprühentwickler bei 2 bar, 35°C während 40 Sekunden, Spülen mit deionisiertem Wasser und Warmlufttrocknen wird die Platte in ein galvanisches Zinnbad getaucht. Im sauren Zinnbad wird kathodisch eine Schicht von ca. 8 µm Dicke an den entwickelten Stellen aufgebaut. Im nächsten Schritt wird das photovernetzte Probimage® 1020 mit 3%-iger Kalilauge bei 60°C in einer Sprühanlage, Sprühdruck 3 bar, behandelt und von der Platte entfernt. Die freigelegten Kupferflachen werden nun mit einer ammoniakalischen
Kupfer(ll)chloridlösung weggeätzt. Die Platte wird mit deionisiertem Wasser gespült, und im letzten Schritt wird das Zinn mit einer sauren Stripperlösung entfernt.
Man erhält eine Innenlage mit Durchkontaktierungen, die nur kleine Restringe von 0,025 mm Ringstärke haben. Die Durchkontaktierungen zeigen keine Anzeichen von Anätzungen.

## Patentansprüche

1. Verfahren zur Herstellung von Leiterplatten mit Durchkontaktierungen, **gekennzeichnet durch** die folgenden Verfahrensschritte:
(A) beidseitiges Beschichten eines durchkontaktierten Kupferlaminats mit einem flüssigen Negativ-Galvanoresist;
(B) Strukturierung der Resistbeschichtung **durch** bildmäßiges Belichten, wobei die Durchkontaktierungen **durch** eine Maske abgedeckt werden, und anschließendes Entwickeln;
(C) Galvanisches Aufbringen eines Metallresists;
(D) Entfernung des auf dem Laminat verbliebenen, vernetzten Negativ-Galvanoresists;
(E) Entfernung des freiliegenden Kupfers mittels einer Ätzlösung; und
(F) Entfernung des Metallresists mittels einer Stripperlösung.

2. Verfahren nach Anspruch 1, **dadurch gekennzeichnet, daß** im Verfahrensschritt (A) das Kupferlaminat mittels Rollenbeschichtung oder Siebdruck beschichtet wird.

3. Verfahren nach Anspruch 1, **dadurch gekennzeichnet, daß** als Metallresist im Verfahrensschritt (C) Zinn, Nickel, Blei, Silber, Gold oder eine Legierung enthaltend eines dieser Metalle eingesetzt wird.

## Claims

1. A method for producing printed circuit boards having through-platings, which comprises the following method steps:
(A) coating both sides of a through-plated copper laminate using a negative electrodeposition-resist;
(B) structuring the resist coating by imagewise exposure to light, the through-platings being covered by a mask, and then developing;
(C) applying a metal resist by electrodeposition;
(D) removing the crosslinked negative galvanoresist remaining on the laminate;
(E) removing the bare copper by means of an etching solution; and
(F) removing the metal resist by means of a stripper solution.

2. A method according to claim 1, wherein in method step (A) the copper laminate is coated by means of roller coating or screen-printing.

3. A method according to claim 1, wherein tin, nickel, lead, silver, gold or an alloy comprising one of those metals is used as the metal resist in method step (C).

## Revendications

1. Procédé pour la fabrication de circuits imprimés par métallisation de trous, **caractérisé par** les étapes de procédé suivantes :
(A) revêtement d'un stratifié de cuivre à trous métallisés, sur les deux faces, d'un galvanoresists négatif, liquide ;
(B) structuration du revêtement de résine photosensible par irradiation selon modèle, les trous métallisés étant recouverts d'un masque, et développement ultérieur ;
(C) déposition par galvanisation d'un resist métallique ;
(D) élimination du galvanoresist négatif, réticulé, restant sur le stratifié ;
(E) élimination du cuivre nu à l'aide d'une solution de décapage ;
(F) élimination du resist métallique à l'aide d'un bain à démétalliser.

2. Procédé selon la revendication 1, **caractérisé en ce que**, à l'étape (A), le stratifié de cuivre est revêtu au moyen d'un couchage sur bande ou de sérigraphie.

3. Procédé selon la revendication 1, **caractérisé en ce qu'**on utilise dans l'étape (C) en tant que resist métallique l'étain, le nickel, le plomb, l'argent, l'or ou un alliage de ces métaux.
